(19) Europäisches Patentamt
European Patent Office
Office européen des brevets

(11) EP 1 245 697 A2

(12) **EUROPÄISCHE PATENTANMELDUNG**

(43) Veröffentlichungstag:
**02.10.2002 Patentblatt 2002/40**

(51) Int Cl.[7]: **C23C 18/42**, C23C 18/24

(21) Anmeldenummer: **02090262.3**

(22) Anmeldetag: **17.07.2002**

(84) Benannte Vertragsstaaten:
**AT BE BG CH CY CZ DE DK EE ES FI FR GB GR IE IT LI LU MC NL PT SE SK TR**
Benannte Erstreckungsstaaten:
**AL LT LV MK RO SI**

(71) Anmelder: **ATOTECH Deutschland GmbH**
**10553 Berlin (DE)**

(72) Erfinder:
- **Schreier, Hans-Jürgen, Dr.**
  **16727 Velten (DE)**
- **Mahlkow, Hartmut**
  **12159 Berlin (DE)**

(74) Vertreter: **Effert, Bressel und Kollegen**
**Radickestrasse 48**
**12489 Berlin (DE)**

# (54) Verfahren zum aussenstromlosen Abscheiden von Silber

(57) Bei der Bildung von löt- und bondbaren Schichten auf Leiterplatten besteht das Problem, daß die Oberflächen nach Lagerung der Platten vor der Weiterverarbeitung (Bestückung mit elektrischen Bauteilen) korrodieren, so daß die Lötund Bondbarkeit beeinträchtigt wird. Um dieses Problem zu lösen, wird vorgeschlagen, auf der Leiterplatte in einem ersten Verfahrensschritt ein Metall abzuscheiden, das edler als Kupfer ist, und in einem zweiten Verfahrensschritt Silber abzuscheiden, mit der Maßgabe, daß das erste Metall mit einer Rate abgeschieden wird, die höchstens halb so groß ist wie die beim Abscheiden von Silber gemäß dem zweiten Verfahrensschritt, wenn das erste Metall Silber ist.

EP 1 245 697 A2

## Beschreibung

Die Erfindung betrifft ein Verfahren zum außenstromlosen Abscheiden von Silber, insbesondere zur Herstellung von Leiterplatten, vorzugsweise zur Bildung von lötbaren oder bondbaren Schichten auf den Löt- und Bondlandeplätzen (Pads).

Zur elektrischen Befestigung von Bauelementen, beispielsweise Widerständen, Kondensatoren und Halbleiterbauelementen wurde bei der Herstellung von Leiterplatten und anderen Schaltungsträgern bisher eine aus einer Legierung aus Zinn und Blei bestehende Lotschicht mit flüssigem Lot auf die desoxidierten Kupferoberflächen aufgetragen und überschüssiges flüssiges Lot an den Oberflächen und insbesondere aus den Löchern mit einem heißen Luftstrahl (Luftmesser) wieder entfernt. Dieses Verfahren ist als Heißluftverzinnungs-Verfahren (Hot-air-leveling-Verfahren: HAL-Verfahren) bekannt. Meist wird das HAL-Verfahren erst nach dem Aufbringen einer Lötstopmaske durchgeführt, die aus einem Polymerfilm besteht und auf die Oberflächen der Leiterplatte mit Ausnahme der Bereiche aufgebracht wird, in denen die Bauelemente verlötet werden sollen. Dadurch gelangt das flüssige Lot ausschließlich zu den Stellen auf den Leiterplatten, an denen die Bauelemente elektrisch kontaktiert werden sollen.

Nach Bildung der Zinn/Blei-Schicht können die Bauelemente entweder im Durchsteckverfahren oder in der Oberflächenmontage auf die Leiterplatte montiert und dort verlötet werden. Da die Bauelemente häufig erst geraume Zeit nach der Herstellung der Leiterstrukturen auf den Leiterplatten montiert und verlötet werden, oxidieren die Kupferoberflächen, so daß deren Benetzbarkeit mit flüssigem Lot enorm herabgesetzt wird. Daher müßten die Leiterstrukturen vor dem Löten von den gebildeten Oxidschichten erst befreit werden. Durch die Bildung der Zinn/Blei-Schicht auf den Leiterstrukturen wird deren Oxidation vermieden, so daß die Bauelemente später problemlos montiert und verlötet werden können. Die mit dem HAL-Verfahren erzeugten Schichten dienen daher auch dazu, die Kupferoberflächen vor fortschreitender Oxidation zu schützen. Mit dem HAL-Verfahren präparierte Flächen lassen sich daher hervorragend löten. Außerdem sind die Leiterplattenoberflächen resistent gegen Oxidation und andere korrosive Prozesse.

Auch wenn bei Durchführung des HAL-Verfahrens eine Vergleichmäßigung der Dicke der Zinn/Blei-Schicht mit dem Luftmesser erreicht werden kann, verbleiben dennoch erhebliche Schichtdickenunterschiede auf den Leiterplattenoberflächen. Mit fortschreitender Erhöhung der Schaltungsdichte und mit Einführung einer automatischen Bestückung mit den Bauelementen müssen jedoch Leiterstrukturen mit möglichst planaren Oberflächen gebildet werden, die mit der HAL-Technik nicht erzielbar sind. Ebenso kommt es bei immer geringeren Abständen der Anschlußstellen für die Bauelemente (Pads) vermehrt zu einer Lotbrückenbildung. Daher sind alternative Verfahren zum HAL-Verfahren gesucht worden, mit denen diese Nachteile der gebildeten Zinn/Blei-Schichten auf den Kupferoberflächen vermieden werden können. Ein primäres Ziel hat dabei darin bestanden, die Oxidation der Kupferoberflächen zu verhindern und gleichzeitig die Anforderungen, die mit der fortschreitenden Miniaturisierung und Automatisierung der Bestückung gestellt werden, zu erfüllen.

Eine Abhilfe dieser Probleme ist durch die Bildung einer Schichtkombination von Nickel und Gold erreicht worden. Da die zu beschichtenden Leiterstrukturen im allgemeinen elektrisch voneinander isoliert sind, werden die beiden Metallschichten mit außenstromlosen Verfahren auf die Kupferoberflächen aufgebracht. Bei einem außenstromlosen Beschichtungsverfahren ist ein elektrischer Anschluß der zu beschichtenden Bereiche der Kupferoberflächen an eine externe Stromquelle nicht erforderlich.

Die Nickel/Gold-Endschicht ist insbesondere für Anwendungen geeignet, bei denen höchste Qualitätsanforderungen bestehen. Sie ist nicht nur löt- sondern auch bondbar und bietet einen hervorragenden Korrosionsschutz. Außerdem kann sie auch zur Herstellung von elektrischen Kontaktflächen, beispielsweise in Schaltern und Steckkontakten eingesetzt werden. Diese Technik ist jedoch sehr teuer, so daß sich deren Anwendung auf hochwertige Schaltungen beschränkt. Eine Massenanwendung bleibt ihr verschlossen.

Eine andere qualitativ hochwertige Endoberfläche wird durch stromlose Beschichtung der Kupferoberflächen mit Palladium gebildet. Mit einer 0,2 µm dicken Palladiumschicht auf Kupfer wird beste Lötbarkeit erreicht. Außerdem sind die Palladiumoberflächen wegen deren geringen Kontaktwiderstandes auch zur Herstellung von Kontaktflächen auf den Leiterplatten geeignet. Wegen des hohen Preises von Palladium verbietet sich allerdings ein Einsatz in der Massenfertigung.

Wesentlich preiswerter als eine Beschichtung mit der Schichtkombination aus Nickel und Gold oder mit Palladium ist die Bildung einer organischen Schutzschicht aus Alkylimidazolen oder Alkylbenzimidazolen auf den Kupferflächen. Diese Schutzschichten bieten einen wirksamen Anlaufschutz gegen die Oxidation der Kupferoberflächen. Außerdem sind sie sehr dünn, so daß sich die durch die ungleichmäßige Schichtdickenverteilung der HAL-Schichten auftretenden Nachteile nicht ergeben.

Nachteilig ist jedoch, daß die genannten organischen Schutzschichten nicht auch uneingeschränkt zum Bonden von ungehäusten Halbleiterbauelementen geeignet sind, die direkt auf die Leiterplatten plaziert werden. Außerdem ist es nicht möglich, eine bereits in einem Lötverfahren beanspruchte Leiterplatte nochmals zu löten, da die Schutzschicht während des ersten Lötvorganges zerstört wird. Auch der Vorteil der Nickel/Gold-Schichtkombination und der

Palladiumschicht, daß elektrische Kontaktflächen auf den Leiterplatten gebildet werden können, kann mit den organischen Schutzschichten nicht realisiert werden.

In einer weiteren Verfahrensalternative werden die Kupferoberflächen der Leiterstrukturen durch Ladungsaustausch mit dem Kupfer stromlos mit Zinn beschichtet. Ebenso wie die organischen Schutzschichten bieten Zinnschichten jedoch nur einen geringen Anlaufschutz. Außerdem sind mit ihnen keine multifunktionalen Oberflächen herstellbar, da mit Zinnoberflächen keine elektrischen Kontakte gebildet werden können. Die Lötbarkeit der Zinnschichten ist zwar gegeben, da mit der Zinnschicht auch ein Anlaufschutz besteht. Mehrfachlötungen sind aber nur unter bestimmten Bedingungen möglich. Außerdem ist es nicht möglich, Kontaktschichten für Schalter und Steckkontakte herzustellen.

Mit dem Verzinnungsverfahren vergleichbar preiswert ist auch eine Beschichtung mit Silber. Schon bei geringen Schichtdicken erfüllt eine Silber-Endschicht auf Kupfer viele Bedingungen einer modernen Endschicht. Silberschichten können insbesondere nicht nur für Lötanwendungen eingesetzt werden, sondern auch für Bondanwendungen. Außerdem weisen diese Schichten auch einen sehr geringen Kontaktwiderstand auf, so daß sie auch zur Bildung von Steckkontakten an Leiterplatten und Schaltern eingesetzt werden können.

Die bekannten Verfahren zur Abscheidung von Silber auf Kupfer beruhen auf dem sogenannten Ladungsaustauschverfahren nach Gleichung **A**:

$$Cu + Ag^{+} \rightarrow Cu^{+} + Ag \qquad \text{A}$$

Die Silberschicht kann etwa 0,2 µm dick sein. Sie schützt das Kupfer vor Oxidation. Durch die Silberoberfläche werden außerdem Mehrfachlötungen ermöglicht. Die Schicht ist planar und eignet sich auch für die Einpreßtechnik, bei der die Anschlußbeine von elektrischen Bauelementen in die Löcher in der Leiterplatte mechanisch eingepreßt werden, so daß ein elektrischer Kontakt mit den Leiterstrukturen gebildet wird. Auch nach Auslagerung einer mit Silberoberflächen versehenen Leiterplatte unter Dampf und Wärme sind die Ergebnisse der Lötbarkeit mit einer klassischen HAL-Oberfläche vergleichbar.

Es hat sich herausgestellt, daß die Lötbarkeit der hergestellten Silberschichten nach einer Lagerung noch nicht ausreichend ist. Daher werden verschiedene Verbesserungen vorgeschlagen:

In EP 0 797 690 B1 ist ein Verfahren zum Beschichten einer gedruckten Leiterplatte beschrieben, bei dem eine Silberbeschichtung durch Ladungsaustausch auf die Kupferflächen aufgetragen wird. Das Silberbad kann u.a. Anlaufschutzmittel enthalten, um die Lötbarkeit nach Lagerung zu gewährleisten. Als Anlaufschutzmittel werden u.a. substitutierte Imidazoline, Alkyl- und Alkylbenzylimidazole, Benzimidazole, Triazolderivate und substituierte Tetrazole genannt. Die Anlaufschutzmittel können auch in einer Nachbehandlung nach der Versilberung angewendet werden. Ein Nachteil dieses Verfahren besteht darin, daß die Anlaufschutzmittel in einigen Fällen umweltschädigend sind. Außerdem hat sich herausgestellt, daß die Löt- und Bondfähigkeit nach längerer Lagerung in einigen Bereichen einer Leiterplatten sehr gut war, in anderen dagegen ein erheblicher Abfall der Beständigkeit gegen Korrosion beobachtet wurde.

In EP 0 797 380 A1 ist ein Verfahren zum Verbessern der Lötbarkeit von Kupferoberflächen, insbesondere von Leiterplatten offenbart, bei dem auf die Oberflächen vor dem Löten eine Silberschicht durch Ladungsaustausch aufgebracht wird. Die Silberschicht wird durch In-Kontakt-Bringen der Oberflächen mit einer sauren Beschichtungslösung gebildet, die einen Silberimidazol-Komplex enthält. Als Silberionenquelle wird vorzugsweise Silbernitrat verwendet.

In US 5,733,599 A ist ein Verfahren zur Verbesserung der Lötfähigkeit von Oberflächen beschrieben, bei dem mit Kupfer beschichtetes Leiterplattenmaterial zunächst mit einer Silberschicht durch Ladungsaustauschreaktion überzogen wird und auf die Silberschicht eine weitere Schicht eines Metalls aufgetragen wird, das ausgewählt ist aus der Gruppe Gold, Ruthenium, Rhodium und Palladium. Die Silberbeschichtungslösung enthält vorzugsweise Silbernitrat, Methansulfonsäure sowie Histidin, um eine verbesserte Lötbarkeit der Oberflächen zu erreichen.

In Patent Abstracts of Japan zu JP 03-002379 A ist ein Verfahren zum Bilden einer Silberschicht auf Kupfer beschrieben, bei dem das Beschichtungsbad zusätzlich zu Silbernitrat eine Alkylimidazolverbindung und eine organische Säure bzw. deren Salz enthält.

Ferner wird in Patent Abstracts of Japan zu JP 06-299375 A ein Behandlungsverfahren für metallische Oberflächen beschrieben, bei dem u.a. Silber mit einer chemischen Umwandlungsschicht überzogen wird, um eine verbesserte Widerstandsfähigkeit gegen Feuchtigkeit, chemische Einflüsse und Wärmeeinwirkung zu erreichen, so daß die Löteigenschaften verbessert werden. Zur Bildung der chemischen Umwandlungsschicht wird die Silberoberfläche mit einer wäßrigen Lösung in Kontakt gebracht, die ein Imidazolderivat enthält.

Weiterhin wird in EP 1 024 211 A2 ein Bad zur Abscheidung einer Silberlegierung beschrieben, die neben Silber auch Palladium, Platin, Gold und/oder Rhodium als Legierungsbestandteile enthält. Es wird angegeben, daß

die Korrosionsbeständigkeit der mit diesem Bad abgeschiedenen Schichten durch diese Legierungsmetalle deutlich gesteigert werde.

Die bekannten Verfahren zur Verbesserung der Lötbarkeit auf Kupferoberflächen weisen folgende Nachteile auf:

Die zur Verbesserung der Lötbarkeit gebildeten Deckschichten sind häufig ungleichmäßig dick. Weiterhin ist es unter Umständen sehr teuer, derartige Schichten herzustellen, insbesondere im Falle einer Nickel/Gold- oder Palladiumschicht. In einigen Fällen werden auch umweltschädliche Bestandteile zu deren Herstellung benutzt, beispielsweise Chrom(VI) enthaltende Lösungen. In vielen Fällen sind die gebildeten Schichten auch nicht geeignet, Bondverbindungen sowie elektrische Kontakte zu bilden. Weiterhin weist das in EP 1 024 211 A2 beschriebene Bad den Nachteil auf, daß sich die Legierungszusammensetzung auf die Korrosionsbeständigkeit der Schutzschicht auswirkt. Da die Legierungszusammensetzung wiederum u.a. von den relativen Konzentrationen von Silber und der Legierungsmetallionen in der Abscheidelösung abhängen, ist die Kontrolle der Schichteigenschaften im Hinblick auf die Korrosionseigenschaften relativ aufwendig.

Ferner ist in DE 100 50 862 A1 vorgeschlagen worden, ein Bad sowie ein Verfahren zum stromlosen Abscheiden von Kupfer auf gegenüber Kupfer unedleren Metalloberflächen durch Ladungsaustauschreaktion, insbesondere auf Kupfer, einzusetzen. Das Bad enthält mindestens einen Silberhalogeno-Komplex, jedoch kein Reduktionsmittel für Silberionen. Als Silberhalogeno-Komplex wird vorzugsweise ein Silberbromo-Komplex eingesetzt. Das in diesem Dokument beschriebene Bad weist jedoch den Nachteil auf, daß Benzotriazol-Verbindungen zugegeben werden müssen, um gute Lötergebnisse zu erhalten. Die Benzotriazol-Verbindungen dienen in erster Linie zum Schutz der erhaltenen Silberschicht vor Oxidation und vor der Gefahr einer Bildung von Korrosionsprodukten aus der Atmosphäre, die in Form von Silber-Schwefel-Verbindungen entstehen können. Außerdem hat es sich herausgestellt, daß bereits nach kurzer Betriebsdauer des Bades nur noch Silberschichten hergestellt werden können, die leicht gelblich und nicht mehr weiß-silberfarben sind, wie unmittelbar nach einem Neuansatz des Bades. Diese Verfärbung der Silberschicht verstärkt sich nach Auslagerung bei trockener Hitze (4 Stunden, 155°C) und bei einem Dampftest (4 Stunden, 98 - 100°C) und wird für die starke Verminderung der Benetzung der Silberschicht mit Lot verantwortlich gemacht.

Nachteilig ist an allen bekannten Verfahren, bei denen die erwähnten Anlaufschutzverbindungen eingesetzt werden, daß diese Mittel im allgemeinen in relativ hoher Konzentration eingesetzt werden müssen, um wirksam zu sein, und daß diese in der Regel umweltbelastend sind. Außerdem hat es sich als nachteilig herausgestellt, daß die gebildeten Silberschichten in diesen Fällen eine relativ rauhe Oberfläche aufweisen, die durch Dendriten hervorgerufen wird.

Der vorliegenden Erfindung liegt von daher die Aufgabe zugrunde, die Nachteile der bekannten Verfahren zu vermeiden und insbesondere ein Verfahren zu finden, mit dem löt- und bondbare Schichten auf den Kupferoberflächen von Löt- und Bondpads gebildet werden können, wobei die Löt- und Bondfähigkeit auch nach längerer Lagerungszeit noch ausreichend hoch ist. Das Verfahren soll vor allem einfach und ohne aufwendige Prozeßkontrolle durchführbar sein. Die Haftfestigkeit der löt- und bondbaren Schutzschicht soll darüber hinaus sehr gut sein, und die gebildeten Schichten sollen auch auf größeren Kupferflächen sehr gleichmäßig aufwachsen.

Gelöst wird dieses Problem durch das Verfahren nach Anspruch 1. Bevorzugte Ausführungsformen der Erfindung sind in den Unteransprüchen angegeben.

Das erfindungsgemäße Verfahren dient zum außenstromlosen Abscheiden von Silber auf einem eine Kupferoberfläche aufweisenden Werkstück. Unter einer außenstromlosen Silberabscheidung kann sowohl eine Abscheidung durch Ladungsaustauschreaktion verstanden werden, bei der das Grundmetall zugunsten des abgeschiedenen Metalls aufgelöst wird, oder eine Abscheidung durch zusätzliche Verwendung eines Reduktionsmittels, das dazu dient, im Abscheidebad enthaltene Metallionen zu Metall zu reduzieren.

Zur Bildung der löt- und bondbaren Oberflächen werden auf dem Werkstück

a) in einem ersten Verfahrensschritt ein Metall abgeschieden, das edler ist als Kupfer, und
b) in einem zweiten Verfahrensschritt außenstromlos Silber abgeschieden.

Falls das erste Metall Silber ist, wird das im ersten Verfahrensschritt abgeschiedene erste Metall (Silber) mit einer Rate abgeschieden, die höchstens halb so groß ist wie die Rate für die Abscheidung von Silber beim zweiten Verfahrensschritt. Vorzugsweise wird das erste Metall mit einer Rate abgeschieden, die höchstens 30 % und insbesondere höchstens 15 % von der Rate entspricht, mit der Silber im zweiten Verfahrensschritt abgeschieden wird.

Die Abscheidungsrate von Silber wird durch die Masse an Silber definiert, die innerhalb einer vorgegebenen Zeitspanne auf einem vorgegebenen Oberflächenbereich des Werkstückes, beispielsweise 1 $dm^2$, abgeschieden wird. Zur Bestimmung der Abscheidungsrate wird auf der Werkstückoberfläche abgeschiedenes Silber gemäß vorliegender Definition durch chemische Mittel (konzentrierte Salpetersäure) wieder abgelöst und die Menge an abgelöstem Silber auf analytischem Wege bestimmt. Beispielsweise kann Silber durch Atomabsorptionsspektrometrie bestimmt werden.

Die Abscheiderate von Silber zur Bildung der löt- und bondbaren Schichten im zweiten Verfahrensschritt

beträgt vorzugsweise 5 - 10 mg/min·dm$^2$. Somit liegt die Abscheiderate für Silber im ersten Verfahrensschritt vorzugsweise im Bereich von 2 - 5 mg/min·dm$^2$, insbesondere bevorzugt im Bereich von 0,2 - 2,0 mg/min·dm$^2$ und ganz besonders bevorzugt im Bereich von 0,7 - 1,5 mg/min·dm$^2$.

Verglichen mit bekannten Verfahren, insbesondere mit dem in EP 0 797 690 B1 beschriebenen Verfahren, zeichnet sich das erfindungsgemäße Verfahren insbesondere dadurch aus, daß eine Silberschicht mit verbesserten Eigenschaften abgeschieden werden kann. Darunter ist vor allem zu verstehen, daß die Lötund Bondbarkeit insbesondere nach Alterung/Lagerung der Schicht besser ist als nach Bildung der Schutzschicht gemäß EP 0 797 690 B1. Die Verbesserung der Lötbarkeit äußert sich dadurch, daß die nach dem erfindungsgemäßen Verfahren hergestellte Schicht nach Alterung signifikant schneller mit Lot benetzt wird als die gemäß EP 0 797 690 B1 hergestellte Schicht.

Um die Lötbarkeit nach Alterung zu simulieren, wird das mit der Schutzschicht überzogene Werkstück nach der Herstellung vier Stunden lang bei 155°C in einem ersten Test in einer trockenen Atmosphäre gelagert, bevor der Benetzungstest durchgeführt wird. Weiterhin wird das beschichtete Werkstück in einem zweiten Test in Dampfatmosphäre über kochendem Wasser vier Stunden lang bei 98 - 100°C gelagert. In beiden Fällen wird die Bildung von Korrosionsprodukten nach Durchführung der Korrosionstests untersucht. Es hat sich herausgestellt, daß eine Rotfärbung bei nach dem in EP 0 797 690 B1 beschriebenen Verfahren hergestellten Schichten auf Werkstücken, die mit einer Kupferoberfläche versehen worden waren, nach den Korrosionstests festgestellt wurde. Dies deutet auf die Bildung von Korrosionsprodukten aus der Kupferoberfläche hin. Dagegen waren die mit einer nach dem erfindungsgemäßen Verfahren hergestellten Schicht versehenen Werkstücke auch nach der Durchführung der Korrosionstests noch vollständig silbrig hell. Dieser Unterschied bestätigt die unterschiedlichen Ergebnisse der Benetzung der Werkstücke mit Lot, die mit den bekannten Silberschichten bzw. mit den nach dem erfindungsgemäßen Verfahren hergestellten Schichten überzogen worden sind.

Außerdem wird eine erhöhte Haftfestigkeit der Silberschicht auf Kupferoberflächen festgestellt, wenn das erfindungsgemäße Verfahren eingesetzt wird. Wird keine Vormetallisierung aufgebracht, so wird die Silberschicht schon in einem sogenannten Tape-Test vollständig von der Unterlage abgezogen. Für diesen Test wird ein Klebestreifen auf die Oberfläche der Silberschicht fest aufgeklebt und dann ruckartig abgezogen. Bei Untersuchung der erfindungsgemäß abgeschiedenen Schichten bleibt die Silberschicht fest an der Kupferoberfläche haften.

Schließlich wird bei Anwendung des erfindungsgemäßen Verfahrens auch eine gleichmäßigere Schichtbildung beobachtet: Wird nämlich beispielsweise das in EP 0 797 690 B1 beschriebene Verfahren zur Schichtabscheidung angewendet, so bildet sich die Schicht zuerst an den Rändern der Werkstücke, in der Mitte dagegen zunächst noch nicht. Erst wenn die Ränder bereits dicht mit einer Silberschicht überzogen sind, bildet sich auch in der Mitte des Werkstücks eine Silberschicht, wobei diese Schicht ein "wolkiges" Aussehen hat, d.h. die Schicht ist an diesen Stellen noch äußerst dünn, so daß die darunter liegende Kupferoberfläche hindurch scheint. Bei Anwendung des erfindungsgemäßen Verfahrens wird die Schicht in allen Oberflächenbereichen des Werkstückes gleichmäßig gebildet, so daß dann, wenn sich an den Rändern des Werkstückes bereits eine dichte Schicht gebildet hat, die Schicht auch im Zentrum der Flächen des Werkstückes dicht ist. Somit wird eine gleichmäßig dicke Schicht auf allen Oberflächenbereichen des Werkstückes gebildet.

Die gebildete Silberschicht ist somit lückenlos und porenfrei und gewährleistet daher, daß derart behandelte Leiterplatten problemlos gelötet und gebondet werden können und daß die Anschlußbeine von elektrischen Bauelementen ohne weiteres mechanisch in durchkontaktierte Löcher in Leiterplatten eingepreßt werden können. Einmal mit flüssigem Lot in Kontakt gebrachte Leiterplatten können zudem nochmals gelötet werden, beispielsweise bei einer Reparatur der Platten.

Dadurch daß die bei der Beschichtung gebildeten Silberschichten die Kupferoberflächen lücken- und porenlos überziehen, sind die derart geschützten Kupferoberflächen auch nach längerer Lagerzeit unter Testbedingungen, wie bei Anwendung von Feuchtigkeit und/oder Hitze, bei denen leicht Oxidschichten gebildet werden können, gut lötbar, obwohl die Dicke der Schichten vorzugsweise im Bereich unter 1 µm liegt. Somit ist es möglich, derart vorbehandelte Kupferoberflächen an Leiterplatten nach der Herstellung der Leiterbahnen zu lagern, bevor die Leiterplatten mit elektrischen Bauteilen bestückt werden. Dadurch werden sowohl die Mantelflächen der Bohrungen als auch die Landeplätze, die zur elektrischen Befestigung der Bauteile dienen, sowie gegebenenfalls auch die Leiterbahnen selbst geschützt. Letztere werden jedoch vor der Beschichtung mit Silber üblicherweise mit einem Lötstoplack überzogen, der lediglich diejenigen Bereiche der Leiterplattenoberfläche frei läßt, in denen elektrische Bauteile kontaktiert werden sollen. Daher wird im allgemeinen zunächst die Lötstoplackschicht auf die Leiterplattenaußenseiten aufgebracht und strukturiert und in den freiliegenden Kupferbereichen anschließend eine Silberschicht abgeschieden.

Das erfindungsgemäße Verfahren ist daher insbesondere vorteilhaft bei der Herstellung von Leiterplatten einsetzbar. In diesem Falle wird Silber auf den Kupferflächen des Leiterplattenmaterials abgeschieden. Selbstverständlich sind auch andere Anwendungen denkbar, beispielsweise bei der Silberbeschichtung für dekorative Zwecke oder bei der Herstellung von elektrisch äußerst gut leitfähigen Überzügen, beispielsweise in elektrischen Hohlleitern.

Somit dient das Verfahren zum Bilden von Silberschutzschichten auf Kupferoberflächen, vor allem auf Leiterplatten, zur nachfolgenden Durchführung eines Lötverfahrens, Bondverfahrens, der Einpreßtechnik und/oder zur

Herstellung von elektrischen Kontakten. Insbesondere bezieht sich die Erfindung auf die Herstellung reiner Silberschichten.

Die mit derartigen Silberschichten versehenen Platten erfüllen alle Anforderungen, die in der Leiterplattentechnik üblich sind. Insbesondere werden Forderungen nach ausreichender Lotbenetzung auch nach Auslagerung unter diversen Bedingungen erfüllt. Außerdem können mit den Silberschichten auch elektrische Kontaktflächen zur Herstellung von Schaltern und Steckkontakten gebildet werden.

Das erste Metall ist edler als Kupfer. Das bedeutet, daß das elektrische Potential dieses Metalls positiver ist als das elektrische Potential von Kupfer, das sich gegenüber einer beliebigen Bezugselektrode, beispielsweise gegenüber einer Silber/Silberchlorid-Elektrode, dann einstellt, wenn die Kupferoberfläche mit dem Abscheidebad für das erste Metall in Kontakt gebracht wird. Durch diese Bedingung wird gewährleistet, daß das erste Metall durch Ladungsaustauschreaktion auf den Kupferoberflächen abgeschieden werden kann. Dieser Begriff gibt an, daß das metallische Kupfer der Kupferoberfläche zugunsten des abzuscheidenden ersten Metalls aufgelöst wird. Ein Beispiel für die Abscheidung von Silber auf den Kupferoberflächen ist unter vorstehender Gleichung **A** angegeben. Bei der Ladungsaustauschreaktion werden also keine externe Stromquelle und auch kein zusätzliches Reduktionsmittel für die Abscheidung des ersten Metalls benötigt.

In einer bevorzugten Ausführungsform der Erfindung ist das erste Metall Palladium oder Gold. Grundsätzlich können auch andere Metalle als Palladium oder Gold eingesetzt werden, beispielsweise Ruthenium oder Rhodium oder ein anderes Element der VIII. Nebengruppe.

Wird eines der vorstehend genannten Metalle zur Bildung von Metallablagerungen auf den Kupferoberflächen eingesetzt, bevor anschließend die eigentliche löt- und bondbare Silberschicht abgeschieden wird, so wird im zweiten Verfahrensschritt eine kompaktere und gleichmäßigere Silberschicht mit höherer Haftfestigkeit auf der Unterlage erreicht als mit bekannten Verfahren. Es ist auch beobachtet worden, daß die löt- und bondbare Silberschicht feinkristalliner ist als dann, wenn das erste Metall vor der Silberabscheidung nicht abgeschieden worden ist.

Da das erste Metall vorzugsweise in sehr geringer Menge auf den Kupferoberflächen abgeschieden wird, wird vermutet, daß das erste Metall keine zusammenhängende Metallschicht auf der Kupferoberfläche ausbildet. Obwohl die nachfolgend abgeschiedene löt- und bondbare Silberschicht also wahrscheinlich in großen Bereichen direkt auf den Kupferoberflächen gebildet wird, ergeben sich die geschilderten Vorteile. Ohne daß nachfolgende theoretische Deutung schutzbeschränkend sein soll, werden die beobachteten Vorteile darauf zurückgeführt, daß das auf die Kupferoberfläche aufgebrachte erste Metall der Kupferoberfläche wahrscheinlich ein positiveres elektrisches Potential aufprägt als der Kupferoberfläche eigen ist. Dadurch wird die Silberabscheidung verzögert, so daß sich Silber in kompakterer Form als bei Durchführung bekannter Verfahren abscheiden kann. Dadurch werden die vorteilhaften Eigenschaften der Silberschicht erreicht.

Anstelle eines Metalls der VIII. Nebengruppe oder von Gold kann auch Silber als erstes Metall abgeschieden werden, da es ebenso wie die zuvor genannten Metalle edler als Kupfer ist. Um auch in diesem Falle zu gewährleisten, daß die erste Metallschicht nicht bereits in wenig kompakter, poröser Form auf die Kupferoberfläche aufgebracht wird, wird Silber in diesem Falle mit einer Rate abgeschieden, die höchstens halb so groß ist wie die beim Abscheiden von Silber gemäß dem zweiten Verfahrensschritt. Somit wird auch in diesem Falle gewährleistet, daß Silber für die Bildung der löt- und bondbaren Schicht verzögert abgeschieden wird. Auch in diesem Falle wird das elektrische Potential der Kupferoberfläche durch die Bildung von Silberablagerungen wahrscheinlich positiver.

Falls das erste Metall Palladium ist, wird dieses aus einem sauren Bad abgeschieden. Vorzugsweise enthält dieses Bad Schwefelsäure. Der pH-Wert dieses Bades kann insbesondere Null betragen. Er kann selbstverständlich auch größer sein und beispielsweise im Bereich von 2 - 3 liegen. Jedoch hat sich herausgestellt, daß ein 0,5 Mol Schwefelsäure pro Liter enthaltendes Bad besonders gut geeignet ist. Ein bevorzugter Bereich für die Schwefelsäurekonzentration ist 0,1 - 2 Mol/l.

Palladium kann in diesem Bad in einer Konzentration von 1 - 100 mg/l, vorzugsweise 15 - 50 mg/l und insbesondere 50 mg/l, enthalten sein.

Ist das erste Metall Silber, wird die Rate beim Abscheiden von Silber im ersten Verfahrensschritt vorzugsweise durch Einstellung mindestens eines Verfahrensparameters der Abscheidung und/oder durch Einstellung der Zusammensetzung eines für die Abscheidung eingesetzten Bades reguliert.

Als Verfahrensparameter, durch den die Abscheidungsrate reguliert werden kann, kommt zum einen die Behandlungstemperatur in Betracht, mit der das Abscheidungsbad betrieben wird, aus der Silber im ersten Verfahrensschritt abgeschieden wird. Beispielsweise kann die Temperatur im Bereich der Raumtemperatur oder wenig darüber liegen, etwa im Bereich von 20 - 35°C.

Das Abscheidebad für Silber im ersten Verfahrensschritt kann ebenso wie für die Bildung der löt- und bondbaren Silberschicht im zweiten Verfahrensschritt Silberhalogenokomplexe in einer sauren Lösung von Silberionen enthalten. Die Silberionen werden vorzugsweise als Silbermethansulfonat eingesetzt. Die Konzentration der Silberionen in der Lösung liegt vorzugsweise im Bereich von 0,5 - 5 g/l, insbesondere bevorzugt von 0,75 - 2 g/l.

Als Silberhalogenokomplexe kommen insbesondere Bromokomplexe in Frage. Nähere Ausführungen hierzu

werden weiter unten zur Zusammensetzung des im zweiten Verfahrensschritt eingesetzten Abscheidebades berichtet. Auch die weiteren Bestandteile des Bades zur Bildung einer ersten Silberablagerung auf der Kupferoberfläche können denen des Bades zur Bildung der löt- und bondbaren Silberschicht im zweiten Verfahrensschritt entsprechen. So kann das Bad zur Bildung der Silberablagerungen im ersten Verfahrensschritt zusätzlich mindestens einen Cu(I)- und mindestens einen Cu(II)-Komplexbildner enthalten. Außerdem können Netzmittel sowie mindestens ein Lösungsvermittler für den Cu(I)-Komplexbildner im Bad enthalten sein.

Auch durch gezielte Einstellung der Zusammensetzung des Abscheidungsbades für Silber im ersten Verfahrensschritt kann die Rate beim Abscheiden von Silber reguliert werden. Beispielsweise kann der vorstehend erwähnte Cu(I)-Komplexbildner in dem für die Abscheidung eingesetzten Bad verwendet bzw. dessen Konzentration auf einen relativ hohen Wert eingestellt werden, um eine verzögerte Ablagerung von Silber auf der Kupferoberfläche zu erreichen. Als Cu(I)-Komplexbildner kann beispielsweise 2,2'-Bipyridyl oder eine andere Verbindung mit dem weiter unten angegebenen Strukturelement **I** eingesetzt werden. Dessen Konzentration im Abscheidebad wird vorzugsweise auf einen Wert von mindestens 200 mg/l eingestellt. Eine obere Grenze dieser Konzentration ist dadurch gegeben, daß Silber unter diesen Bedingungen auf der Kupferoberfläche überhaupt nicht mehr abgeschieden werden kann. Ferner können auch andere Inhibitoren, die die Silberabscheidung verlangsamen, verwendet werden.

Außerdem bestimmen auch die Wahl der Säure und der pH-Wert die Abscheidungsrate, so daß auch durch deren Optimierung die Qualität der nachfolgend abgeschiedenen Silberschicht reguliert werden kann.

Die löt- und bondbare Silberschicht, die im zweiten Verfahrensschritt abgeschieden wird, wird vorzugsweise durch Ladungsaustauschreaktion auf den Kupferoberflächen abgeschieden. Silber scheidet sich auch in diesem Falle gemäß Gleichung **A** unter Auflösung von Kupfer ab. Das bedeutet, daß das Bad vorzugsweise kein Reduktionsmittel enthält. Silber wird in diesem Falle ausschließlich oder zumindest überwiegend durch eine Ladungsaustauschreaktion mit dem zu beschichtenden Metall reduziert. Die in dem Bad enthaltenen Silberionen, vorzugsweise Silber(I)-Ionen, werden zu metallischen Silber reduziert, indem gleichzeitig das zu beschichtende Kupfer oxidiert und dabei aufgelöst wird. Die zu beschichtende Kupferoberfläche wird solange mit einer Silberschicht überzogen, bis die Kupferoberfläche lückenlos und porenfrei mit Silber bedeckt ist. Sobald dies erreicht ist, kommt das zu beschichtende Metall nicht mehr mit Silberionen in Kontakt, so daß die Redoxreaktion zum Erliegen kommt

Das Bad für die Bildung der löt- und bondbaren Silberschicht enthält Silberionen sowie mindestens einen Cu (I)-Komplexbildner, der ausgewählt ist aus der Gruppe umfassend Verbindungen mit dem Strukturelement **I:**

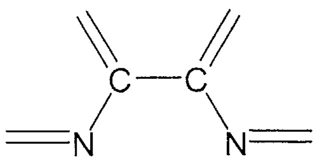

**I**

Der Cu(I)-Komplexbildner im Bad, der das Strukturelement **I** enthält, kann vorzugsweise zur Gruppe der Ferroin-Verbindungen gehören. In diesem Falle weist der Komplexbildner das vorgenannte Strukturelement **I** auf. Gegebenenfalls kann der Komplexbildner auch zur Cuproin-Gruppe gehören. In diesem Falle ist das vorgenannte Strukturelement **I** wie nachstehend angegeben erweitert:

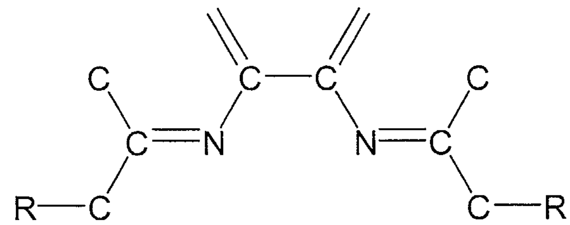

I′

In einigen Fällen kann der Komplexbildner auch zur Terroin-Gruppe gehören, deren Verbindungen nachstehendes Strukturelement **I"** aufweisen, das in zwei tautomeren Formen vorliegen kann:

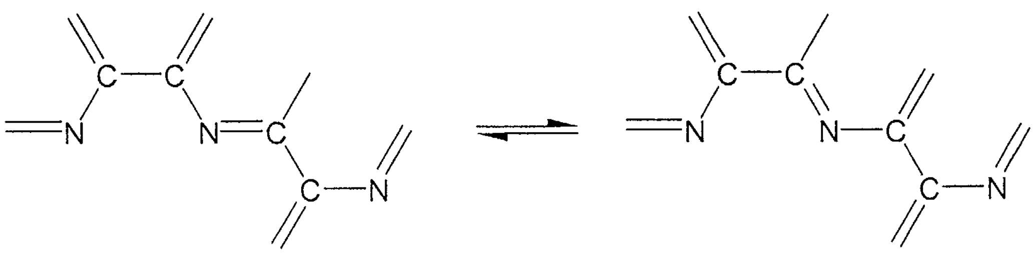

I″

Die Verbindungen mit dem Strukturelement **I** weisen insbesondere folgende allgemeine Strukturformel **II** auf:

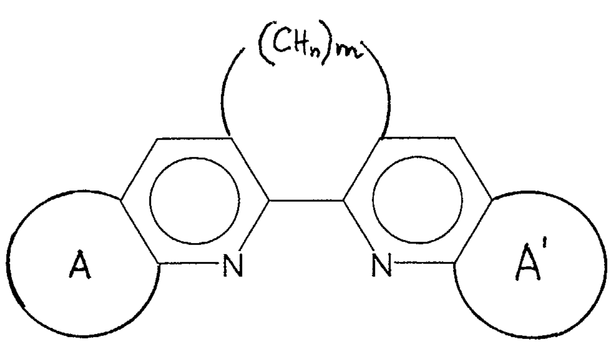

II

wobei

$(CH_n)_m$ für eine Kohlenwasserstoffbrücke steht, wobei n und m unabhängig voneinander für 0 oder 1 oder 2 stehen und

gegebenenfalls an den Grundkörper $C_5N$-$NC_5$ kondensierte aromatische Ringe A und A' vorgesehen sind (in einer Ausführungsform der Erfindung sind keine Ringe an den Grundkörper kondensiert).

Vorzugsweise steht $(CH_n)_m$ in der Strukturformel **II** für eine Ethenylgruppe. Ferner können die Ringe A und A' an den Grundkörper $C_5N$-$NC_5$ kondensierte Benzolringe darstellen.

Die Silberschicht weist vorzugsweise eine Dicke von unter 1 µm, insbesondere von 0,2 bis 0,5 µm, auf. Die Dicke beträgt insbesondere bevorzugt 0,2 µm. Dieser Wert hängt jedoch u.a. von der Oberflächenstruktur der Kupferoberflächen und von der Zusammensetzung des Abscheidebades ab. Je rauher die Kupferoberflächen sind, desto dickere Silberschichten können gebildet werden.

Das Abscheidebad für den zweiten Verfahrensschritt enthält bevorzugt mindestens einen Cu(I)-Komplexbildner, ausgewählt aus der Gruppe umfassend 2,2'-Bipyridin, 1,10-Phenanthrolin, 2,6-Bis-[pyridyl-(2)]-pyridin, 2,2'-Bichinolin (Cuproin), 2,2'-Bipyridin-5-carbonsäure, 2,2'-Bipyridin-4,4'-dicarbonsäure, 4,7-Dihydroxy-1,10-phenanthrolin, sowie Derivate dieser Verbindungen.

Die Konzentration des mindestens einen Cu(I)-Komplexbildners liegt vorzugsweise im Bereich von 10 - 500 mg/l, vorzugsweise im Bereich von 50 - 100 mg/l und insbesondere im Bereich von 20 - 30 mg/l.

Das Silberbad enthält die Silberionen vorzugsweise in Form eines Silberkomplexes. Beispielsweise kann das Bad einen Silberhalogeno-Komplex ($AgCl_{n+1}{}^{n-}$), insbesondere einen Bromokomplex ($AgBr_2^-$, $AgBr_3^{2-}$, $AgBr_4^{3-}$) enthalten. Selbstverständlich können auch andere Komplexe, beispielsweise Silberchloro- oder Silberiodo-Komplexe eingesetzt werden. Zur Herstellung dieser Komplexe werden die entsprechenden Silber(I)-Ionen und Halogenidionen miteinander zur Reaktion gebracht, indem beispielsweise ein Silber(I)-Salz mit einem Halogenidsalz in einer Lösung vermischt wird. In der vorzugsweise wäßrigen Lösung bilden sich je nach den molaren Verhältnissen der Silber(I)-Ionen-Verbindung und der Halogenidverbindung komplexe Anionen gemäß nachfolgender Gleichung **B**:

$$AgX + nX^- \rightarrow AgX^{n-}{}_{n+1} \qquad \text{B}$$

Die Stabilität der Komplexe nimmt in der Reihe Cl < Br < I zu. Im Falle der Halogenokomplexe bilden sich bevorzugt die komplexen Anionen $AgCl_2^-$, im Falle der Bromokomplexe vorzugsweise die komplexen Anionen $AgBr_2^-$ und $AgBr_3^{2-}$Zur Herstellung der Halogenokomplexe können in der wäßrigen Lösung beispielsweise Silberalkansulfonat, insbesondere Silbermethansulfonat, Silberacetat oder Silbersulfat mit den Alkali- oder Erdalkalihalogeniden oder den Halogenwasserstoffsäuren in stöchiometrischem Verhältnis vermischt werden (beispielsweise 0,01 Mol $Ag^+$ pro 2 - 3 Mol Halogenid), wobei sich die komplexen Anionen bilden. Vorzugsweise bilden sich diese Anionen auch bei der Mischung der beiden Spezies, wenn diese nicht in stöchiometrischem Verhältnis miteinander vermischt werden. Vorzugsweise wird ein Überschuß der Halogenidionenquelle eingesetzt. Für die meisten Anwendungen wird eine Silberionenkonzentration im Bad von etwa 1 g/l eingestellt. Die Konzentration kann im Bereich von 0,1 - 20 g/l liegen.

Durch den Einsatz von Silberhalogenid-Komplexverbindungen, die in einem Überschuß von Alkalihalogenid in Lösung gebracht werden, können stabile Silberabscheidelösungen in Wasser gebildet werden. Die Menge freier Silberionen ($Ag^+$) ist in einer derartigen Lösung soweit zurückgedrängt, daß durch die Austauschreaktion zwischen Kupfermetall und Silberionen stabile festhaftende Silberschichten gebildet werden. Die Bäder sind gegen Säuren stabil, so daß die Silberschichten auch bei Einstellung des Bades im stark sauren pH-Bereich abgeschieden werden können.

Der pH-Wert des Bades wird mit pH-Einstellmitteln mit Säuren oder Basen auf einen Wert im Bereich von 0 - 7, vorzugsweise im Bereich von 4 - 6 und insbesondere bei 5,5, eingestellt, beispielsweise mit den den komplexen Anionen entsprechenden Halogenwasserstoffsäuren, nämlich Chlorwasserstoffsäure, Bromwasserstoffsäure und/oder Iodwasserstoffsäure, oder auch mit einem Alkalihydroxid oder Carbonat.

Anstelle der oder zusätzlich zu den Halogenwasserstoffsäuren können auch andere Säuren in der Lösung enthalten sein. Geeignet sind grundsätzlich alle bekannten Mineralsäuren und/oder organischen Säuren sowie deren Mischungen.

Um sicherzustellen, daß die Leiterplatten auch mehrmals mit flüssigem Lot in Kontakt gebracht werden können, ohne daß die Lötbarkeit beeinträchtigt wird, müssen möglichst lückenlose und porenfreie Silberschichten gebildet werden, da sich andernfalls bereits durch einen einzigen Lötvorgang Oxidschichten auf den freiliegenden Stellen der Kupferoberflächen ausbilden. In diesem Falle würde die Benetzbarkeit der gesamten Oberfläche mit Lot deutlich beeinträchtigt. Daher müssen normalerweise relativ dicke Silberschichten abgeschieden werden, um die genannten Anforderungen zu erfüllen. Im vorliegenden Falle reichen dagegen bereits Silberschichten mit einer Dicke von 0,2 - 0,3 µm aus.

Hierzu kann die erfindungsgemäße saure Lösung auch mindestens einen Cu(II)-Komplexbildner enthalten. Vorzugsweise werden Komplexbildner aus der Gruppe, umfassend Polyamine, Aminocarbonsäuren und Aminophosphonsäuren, eingesetzt. Besonders geeignet sind Ethylendiamin, Alanindiessigsäure, Aminotrimethylenphosphonsäure, Diethylentriaminpentamethylenphosphonsäure und 1-Hydroxyethylen-1,1-diphosphonsäure. Die Konzentration des Cu(II)-Komplexbildners liegt vorzugsweise im Bereich von 5 - 500 mg/l, insbesondere bevorzugt im Bereich von 20 - 150 mg/l.

Durch die Verwendung des Cu(II)-Komplexbildners wird die Bildung von Lücken und Poren in der Silberschicht weiter vermindert. Da sich insbesondere in Poren in der Silberschicht leicht Reaktionsprodukte von Kupfer aus der Ladungsaustauschreaktion anreichern, wird die Austauschreaktion wahrscheinlich behindert. Der Cu(II)-Komplexbildner dient offensichtlich dazu, die Cu(II)-Ionen besser zu solubilisieren, so daß die Ladungsaustauschreaktion leichter

vonstatten gehen kann.

Durch Zugabe des Cu(I)-Komplexbildners zu der erfindungsgemäßen sauren Lösung wird die Abscheidegeschwindigkeit reduziert. Wird beispielsweise bei einer Silberabscheidung durch Ladungsaustauschreaktion innerhalb von 5 Minuten bei einer Temperatur von 50°C eine Silberschicht mit einer Schichtdicke von 0,6 µm auf Kupfer erhalten, wenn kein Cu(I)-Komplexbildner in der Lösung enthalten ist, so wird die Schichtdicke nach Zugabe von beispielsweise 5 mg 2,2'-Bipyridin auf 0,4 µm verringert. Durch Zugabe des Cu(I)-Komplexbildners wird das Aussehen der Schicht verbessert und die Neigung zur Bildung von Dendriten verringert. Bei Verwendung der erfindungsgemäßen sauren Lösungen werden auch bei der Betrachtung durch ein Lichtmikroskop einheitlich kristalline Silberschichten ohne Dendriten erhalten.

Allerdings hat sich herausgestellt, daß die Haftfestigkeit und Lötbarkeit derartiger Schichten für den Einsatz in der Leiterplattenindustrie noch nicht ausreichend ist. Zu diesem Zweck wird die Konzentration des Cu(I)-Komplexbildners erhöht. Wird der Gehalt an 2,2'-Bipyridin nämlich auf 10 - 100 mg/l erhöht, so werden haftfeste Silberschichten erhalten. Das Aussehen der Schicht bei Betrachtung unter dem Lichtmikroskop selbst bei 500 - 1000-facher Vergrößerung ist feinkristallin; Dendriten werden unter diesen Bedingungen nicht beobachtet. Auch bei Betrachtung durch das Mikroskop sind Poren nicht zu erkennen, so daß auch keine freien Kupferflächen zu sehen sind. Allerdings wird die mittlere Dicke der Silberschicht unter diesen Bedingungen auf nur noch 0,2 - 0,3 µm verringert. Trotzdem bestehen auf diese Weise erhaltene silbrig hellglänzende Silberschichten die erforderlichen Löttests selbst nach trockener Hitze und nach einem Dampftest problemlos. Die erforderliche Lagerfähigkeit ist somit gewährleistet. Eine optische Verfärbung der Silberschicht nach den zuvor beschriebenen Auslagerungstests wird nicht beobachtet; die Schichten sind auch nach einer Auslagerung silbrig hellglänzend.

Das Silberbad kann zusätzlich auch mindestens einen Lösungsvermittler für den Cu(I)-Komplexbildner, wie einen Polyglykolether, enthalten, beispielsweise ein Polyethylenglykol, ein Polypropylenglykol und/oder ein Copolymer oder Blockpolymer von Ethylenglykol und Propylenglykol. Die Konzentration des Lösungsvermittlers liegt vorzugsweise im Bereich von 5 - 500 g/l, insbesondere bevorzugt im Bereich von 20 - 150 g/l.

Ferner kann das Silberbad auch ein Netzmittel enthalten, beispielsweise ein nichtionisches Netzmittel, insbesondere ein Polyamid. Besonders bevorzugt ist ein Polycaprolactam, das mit Polyethylenglykol blockpolymerisiert ist, beispielsweise das Produkt Lurotex® A25 von BASF, Ludwigshafen. Durch Verwendung dieses Netzmittels wird die Silberschicht noch geschlossener abgeschieden. Das bedeutet, daß die Korrosionsneigung nach Auslagerung verringert ist. Das Netzmittel wird in einer sehr geringen Konzentration eingesetzt, beispielsweise im Bereich von 5 - 100 mg/l Bad. Selbstverständlich ist es auch möglich, das Netzmittel auch dann in dem vorstehend beschriebenen Silberbad einzusetzen, wenn zuvor nicht in erfindungsgemäßer Weise in einem ersten Verfahrensschritt ein erstes Metall, beispielsweise Palladium, auf die Kupferoberfläche abgeschieden worden ist.

Silber scheidet sich aus den Abscheidebädern auf Kupferoberflächen schon unterhalb von 20°C ab. Die Abscheiderate wird über die Temperatur der Lösung und die Silberionenkonzentration beeinflußt. Für ein im ersten Verfahrensschritt eingesetztes Silberbad kann daher vorzugsweise eine Temperatur im Bereich von 20 - 35°C gewählt werden. Für das im zweiten Verfahrensschritt eingesetzte Silberbad wird dagegen vorzugsweise eine Arbeitstemperatur im Bereich von 35 - 65°C eingestellt.

Die erforderliche Dicke der Silberschicht wird im zweiten Verfahrensschritt in sehr kurzer Zeit erreicht. Innerhalb von 1 - 10 Minuten wird eine Schicht mit einer Dicke von 0,2 - 0,5 µm Silber abgeschieden. Deshalb eignet sich diese Lösung hervorragend für eine horizontale Leiterplattenproduktion. Die Wahl der Säure und der pH-Wert bestimmen ebenfalls die Abscheidungsrate.

Zur Durchführung des erfindungsgemäßen Verfahrens werden die Abscheidebäder bereitgestellt und die Metalloberflächen mit diesen in Kontakt gebracht. Üblicherweise werden die Leiterplatten in vertikaler Lage hängend in die hierfür vorgesehenen Behälter eingesenkt, in denen sich die Behandlungsflüssigkeiten befinden (Tauchverfahren). Alternativ können auch Behandlungsanlagen eingesetzt werden, in denen die Platten in horizontaler Lage gehalten und durch die sie in horizontaler Richtung hindurch transportiert werden (Horizontaltechnik). In diesem Falle wird die Behandlungsflüssigkeit über Düsen (Sprühdüsen, Spritzdüsen, Schwalldüsen) einseitig oder beidseitig an die Oberflächen der mittels geeigneter Transportorgane (Rollen, Klammern) beförderten und geführten Platten befördert. Die Platten können in den Horizontalanlagen auch in vertikaler Lage und in horizontaler Transportrichtung durch die Anlage befördert werden.

Vor der Beschichtung der Kupferoberflächen mit Silber werden die Flächen vorzugsweise gereinigt und aufgerauht, um die Haftfestigkeit der Silberschicht auf der Unterlage zu verbessern. Zur Reinigung kann beispielsweise eine Netzmittel enthaltende saure Lösung eingesetzt werden. Dies ist aber nicht unbedingt erforderlich, wenn die Platten vor der Silberbeschichtung nicht unsachgemäß behandelt wurden.

Gegebenenfalls werden die Platten danach gespült, um Reste der Reinigungsflüssigkeit von den Kupferoberflächen zu entfernen.

Danach können die Kupferoberflächen mit einer chemischen Ätzlösung aufgerauht und/oder gereinigt werden. Hierzu können in der Leiterplattentechnik übliche saure Ätzlösungen eingesetzt werden, die mindestens eine

Peroxoverbindung enthalten, beispielsweise eine saure Alkaliperoxodisulfat-, Alkalicaroatoder Wasserstoffperoxid-Lösung, insbesondere eine Natriumperoxodisulfat-Lösung. Alternativ kann auch eine Kupfer(II)-chlorid-Ätzlösung verwendet werden. Im Anschluß an die Behandlung mit der Ätzlösung wird die Platte üblicherweise nochmals gespült, bevor diese mit der sauren Versilberungslösung in Kontakt gebracht wird.

Nach Abschluß der Silberbeschichtung wird die Platte im allgemeinen nochmals gespült und anschließend getrocknet.

Das nachfolgende erfindungsgemäße Beispiel dient zur näheren Erläuterung der Erfindung.

**Beispiel:**

Leiterplattenmaterial (5 cm x 5 cm großer Leiterplattenabschnitt) mit außenliegender Kupferkaschierung wurde in Vertikaltechnik gemäß nachfolgender Beschreibung behandelt:

Zunächst wurde das Material mit üblichen Methoden gereinigt und oberflächlich angeätzt. Nach dem Spülen wurde das Material 30 Sekunden lang in einem ersten Verfahrensschritt mit einer Lösung bei Raumtemperatur, die

| | |
|---|---|
| $PdSO_4$ | 50 mg $Pd^{2+}$/l |
| $H_2SO_4$, konz. | 5 Gew.-% |

enthielt, behandelt. Danach wurde das Material ohne Spülen in einem zweiten Verfahrensschritt 5 Minuten lang mit einem Bad bei 50°C behandelt, das

| | |
|---|---|
| Ag-Methansulfonat | 1 g $Ag^+$ / l |
| NaBr | 320 g / l |
| Dequest 2066A *) | 30 ml / l |
| Polyethylenglykol | 80 ml / l |
| 2,2'-Bipyridyl | 90 mg / l |
| Lurotex® A25**) | 20 mg / l |
| pH | 5,5 |

*) Diethylentriaminpentamethylenphosphonsäure

**) Produkt der BASF, Ludwigshafen (Polycaprolactam, blockpolymerisiert mit Polyethylenglykol)

enthielt. Während der Behandlung wurde fortwährend Luft in die Silberlösung eingeblasen. Anschließend wurde das Material wiederum in deionisiertem Wasser sorgfältig gespült und schließlich getrocknet.

Bei der Behandlung im ersten Verfahrensschritt war noch keine Verfärbung der Kupferoberfläche erkennbar. Nach 30 Sekunden langer Behandlung im zweiten Verfahrensschritt konnte dagegen eine silbrige Verfärbung festgestellt werden.

Nach 5 Minuten bildete sich eine geschlossene Silberschicht aus.

Nach einer 4 Stunden langen Auslagerung des Materials in trockner Wärme bei 155°C wurde keine Verfärbung der Silberschicht beobachtet. In Fig. 2A ist eine Ansicht des beschichteten Material erkennbar. Die Schicht ist gleichmäßig dicht.

Die Lötbarkeit eines auf diese Weise bearbeiteten Materials wurde mit einer Lötwaage untersucht. Hierzu wurde ein kleiner Streifen des Materials an einer Waage befestigt und langsam in flüssiges Lot bei 235°C eingetaucht. Die bei der Benetzung auftretenden Kräfte (Fr [mN/mm]) wurden als Funktion der Zeit t [s] registriert. In Fig. 1A sind mehrere Benetzungskurven wiedergegeben, die mit identisch hergestellten Proben erhalten wurden. Es ist zu erkennen, daß die Benetzung bereits nach weniger als einer halben Sekunde vollständig war. Die nach unten gerichteten Zacken sind auf Artefakte bei der Messung zurückzuführen.

**Vergleichsbeispiel:**

Beispiel 1 wurde wiederholt. Im Unterschied zu Beispiel 1 wurde das Material jedoch nicht in der schwefelsauren Palladiumsulfat-Lösung behandelt sondern nach dem Reinigen und Ätzen sofort in dem Versilberungsbad.

Das Aussehen der Silberschicht ist in Fig. 2B erkennbar. Die Schicht ist nicht gleichmäßig dicht. Sie hat ein "wolkiges" Aussehen.

Nach einem 4 Stunden dauernden Auslagerungstest bei trockner Wärme bei 155°C wurden die Benetzungsprofile gemäß Fig. 1B erhalten, die jeweils mit auf identische Weise hergestellten Proben erhalten wurden. In diesen Fällen wurde eine Zeitspanne von mindestens 0,7 Sekunden registriert, bis die Benetzung der Materialoberflächen mit

flüssigem Lot vollständig war.

## Patentansprüche

1. Verfahren zum außenstromlosen Abscheiden von Silber auf einem eine Kupferoberfläche aufweisenden Werkstück, bei dem auf dem Werkstück

   a) in einem ersten Verfahrensschritt ein Metall abgeschieden wird, das edler als Kupfer ist, und
   b) in einem zweiten Verfahrensschritt Silber abgeschieden wird, mit der Maßgabe, daß das erste Metall mit einer Rate abgeschieden wird, die höchstens halb so groß ist wie die beim Abscheiden von Silber gemäß dem zweiten Verfahrensschritt, wenn das erste Metall Silber ist.

2. Verfahren nach Anspruch 1, **dadurch gekennzeichnet, daß** das erste Metall Palladium oder Gold ist.

3. Verfahren nach Anspruch 2, **dadurch gekennzeichnet, daß** Palladium aus einer sauren Lösung abgeschieden wird.

4. Verfahren nach einem der Ansprüche 2 und 3, **dadurch gekennzeichnet, daß** Palladium aus einer Schwefelsäure enthaltenden Lösung abgeschieden wird.

5. Verfahren nach Anspruch 1, **dadurch gekennzeichnet, daß** das erste Metall Silber ist und daß die Rate beim Abscheiden von Silber im ersten Verfahrensschritt durch Einstellung mindestens eines Verfahrensparameters der Abscheidung und/oder durch Einstellung der Zusammensetzung eines für die Abscheidung eingesetzten Bades reguliert wird.

6. Verfahren nach Anspruch 5, **dadurch gekennzeichnet, daß** die Rate beim Abscheiden von Silber im ersten Verfahrensschritt durch Einstellung der Behandlungstemperatur bei der Abscheidung reguliert wird.

7. Verfahren nach einem der Ansprüche 5 und 6, **dadurch gekennzeichnet, daß** die Rate beim Abscheiden von Silber im ersten Verfahrensschritt durch Verwendung eines Cu(I)-Komplexbildners in dem für die Abscheidung eingesetzten Bad reguliert wird.

8. Verfahren nach einem der vorstehenden Ansprüche, **dadurch gekennzeichnet, daß** Silber im zweiten Verfahrensschritt durch Ladungsaustauschreaktion auf die Kupferoberflächen abgeschieden wird.

9. Verfahren nach einem der vorstehenden Ansprüche, **dadurch gekennzeichnet, daß** Silber im zweiten Verfahrensschritt mit einem Bad abgeschieden wird, das mindestens einen Silberhalogenokomplex enthält.

10. Verfahren nach einem der vorstehenden Ansprüche, **dadurch gekennzeichnet, daß** Silber im zweiten Verfahrensschritt mit einem Bad abgeschieden wird, das mindestens einen Silberbromokomplex enthält.

11. Verfahren nach einem der vorstehenden Ansprüche, **dadurch gekennzeichnet, daß** Silber im zweiten Verfahrensschritt mit einem Bad abgeschieden wird, das einen pH-Wert im Bereich von 4 bis 6 aufweist.

12. Verfahren nach einem der vorstehenden Ansprüche, **dadurch gekennzeichnet, daß** Silber im zweiten Verfahrensschritt mit einem Bad abgeschieden wird, das zusätzlich mindestens einen Cu(I)-Komplexbildner enthält.

13. Verfahren nach Anspruch 12, **dadurch gekennzeichnet, daß** der mindestens eine Cu(I)-Komplexbildner ausgewählt wird aus der Gruppe der Verbindungen, umfassend 2,2'-Bipyridin, 1,10-Phenanthrolin, 2,6-Bis-[pyridyl-(2)-]-pyridin, 2,2'-Bichinolin, 2,2'-Bipyridin-5-carbonsäure, 2,2'-Bipyridin-4,4'-dicarbonsäure, 4,7-Dihydroxy-1,10-phenanthrolin sowie Derivate dieser Verbindungen.

14. Verfahren nach einem der vorstehenden Ansprüche, **dadurch gekennzeichnet, daß** Silber im zweiten Verfahrensschritt mit einem Bad abgeschieden wird, das zusätzlich mindestens einen Cu(II)-Komplexbildner enthält.

15. Verfahren nach Anspruch 14, **dadurch gekennzeichnet, daß** der mindestens eine Cu(II)-Komplexbildner ausgewählt wird aus der Gruppe der Verbindungen, umfassend Ethylendiamin, Alanindiessigsäure, Aminotrimethylenphosphonsäure, Diethylentriaminpentaphosphonsäure und 1-Hydroxyethylen-2,2-diphosphonsäure.

**16.** Verfahren nach einem der vorstehenden Ansprüche, **dadurch gekennzeichnet, daß** Silber im zweiten Verfahrensschritt mit einem Bad abgeschieden wird, das zusätzlich mindestens ein Netzmittel enthält.

**17.** Verfahren nach einem der vorstehenden Ansprüche, **dadurch gekennzeichnet, daß** das Werkstück vor Durchführung des ersten Verfahrensschritts gereinigt und/oder geätzt wird.

**18.** Verfahren nach Anspruch 17, **dadurch gekennzeichnet, daß** das Werkstück vor der außenstromlosen Abscheidung von Silber zum Reinigen und/oder Ätzen mit einer sauren Lösung, enthaltend mindestens eine Peroxoverbindung, ausgewählt aus der Gruppe, umfassend Alkaliperoxodisulfat, Alkalicaroat und Wasserstoffperoxid, in Kontakt gebracht wird.

**19.** Verfahren nach einem der vorstehenden Ansprüche, **dadurch gekennzeichnet, daß** das Verfahren als Horizontaldurchlaufverfahren durchgeführt wird.

**20.** Verfahren nach einem der vorstehenden Ansprüche, **dadurch gekennzeichnet, daß** das Werkstück Leiterplattenmaterial ist und daß Silber in dem zweiten Verfahrensschritt zur nachfolgenden Durchführung eines Lötverfahrens, Bondverfahrens, für die Einpreßtechnik und/oder zur Herstellung von elektrischen Kontakten abgeschieden wird.

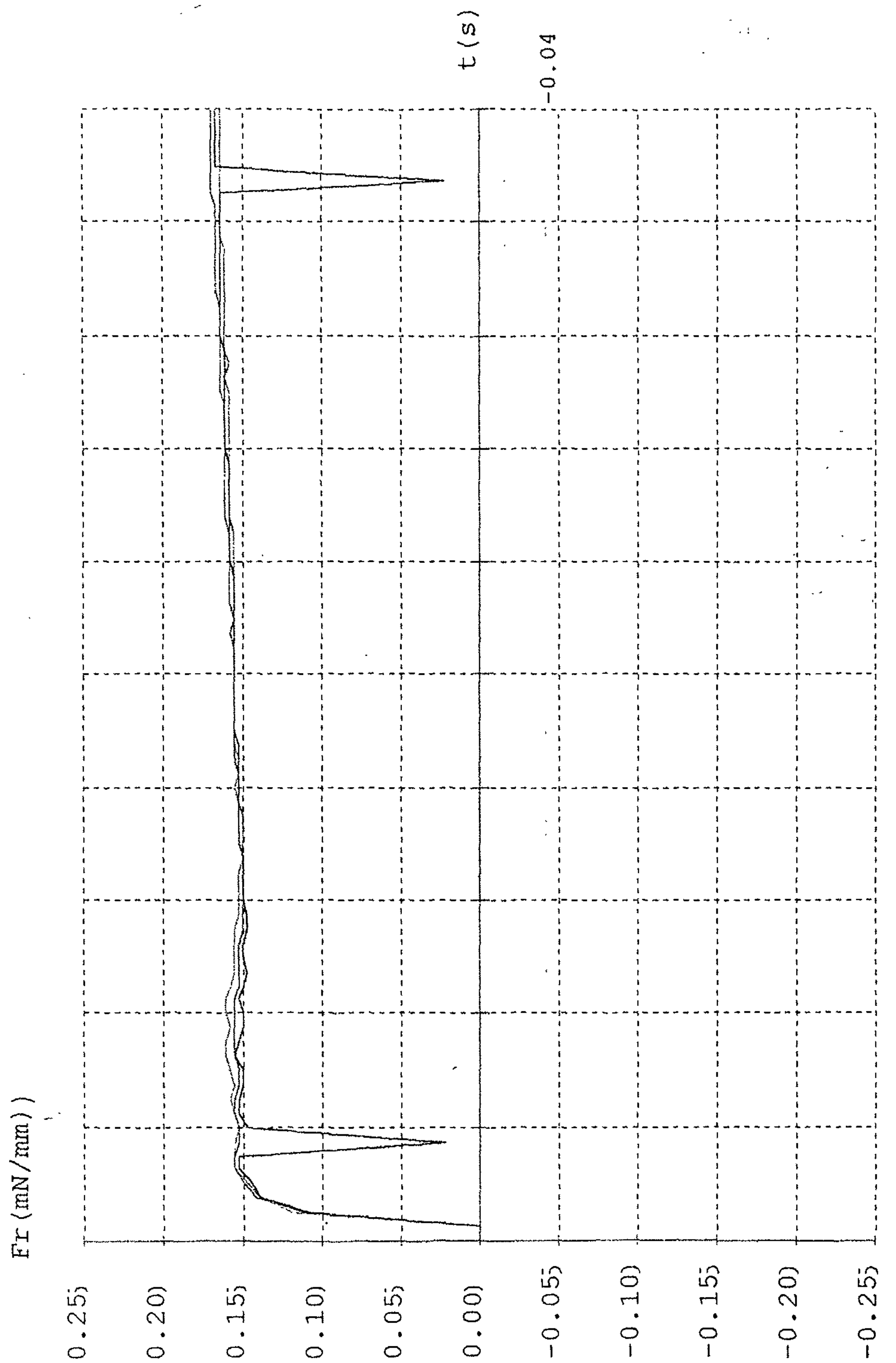
Fr (mN/mm))
t(s)
-0.04
0.25
0.20
0.15
0.10
0.05
0.00
-0.05
-0.10
-0.15
-0.20
-0.25
1
2
3
4
5
6
7
8
9
10

Fig. 1A

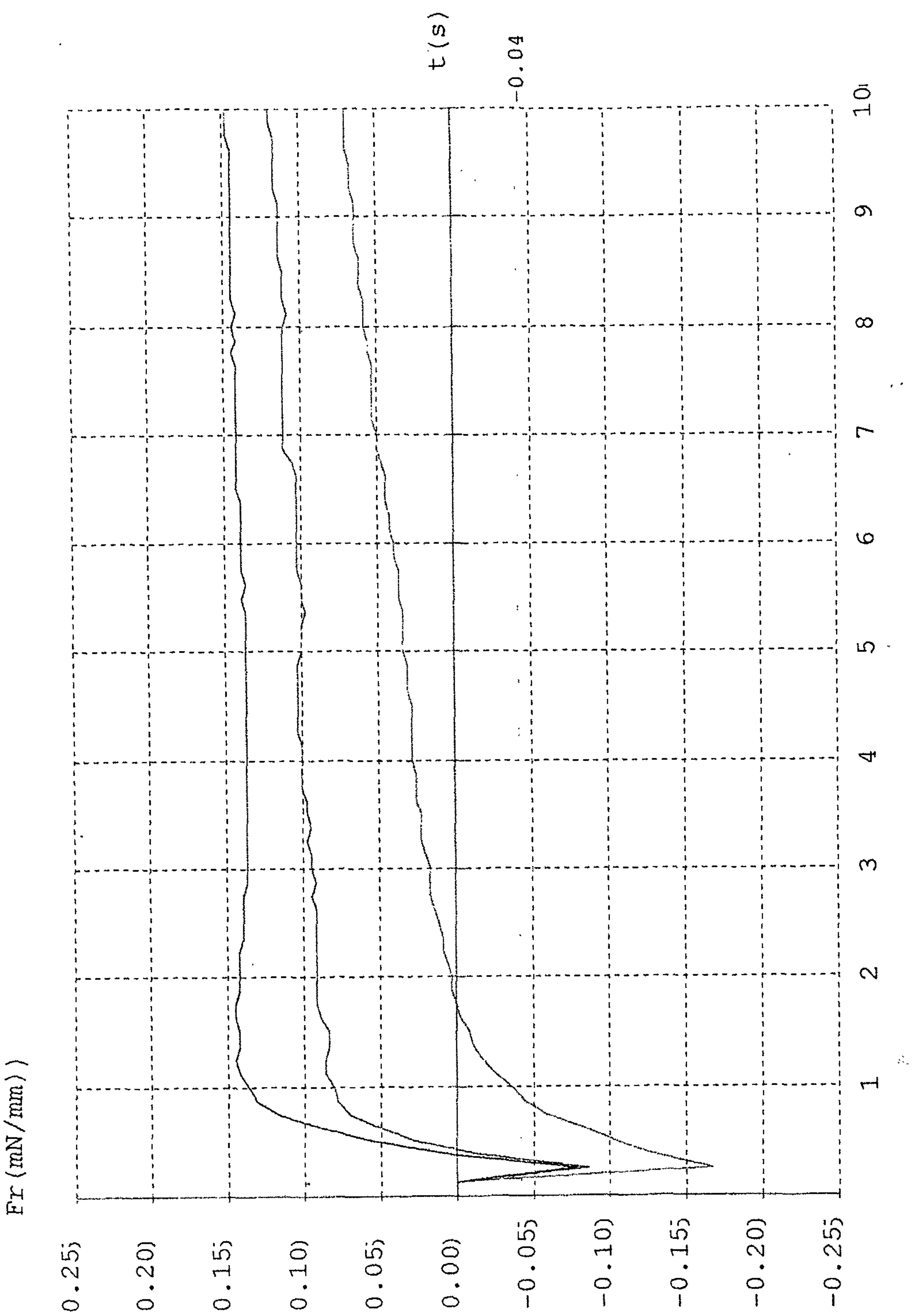
Fr (mN/mm))
t(s)
-0.04
0.25
0.20
0.15
0.10
0.05
0.00
-0.05
-0.10
-0.15
-0.20
-0.25
1
2
3
4
5
6
7
8
9
10

Fig. 1B

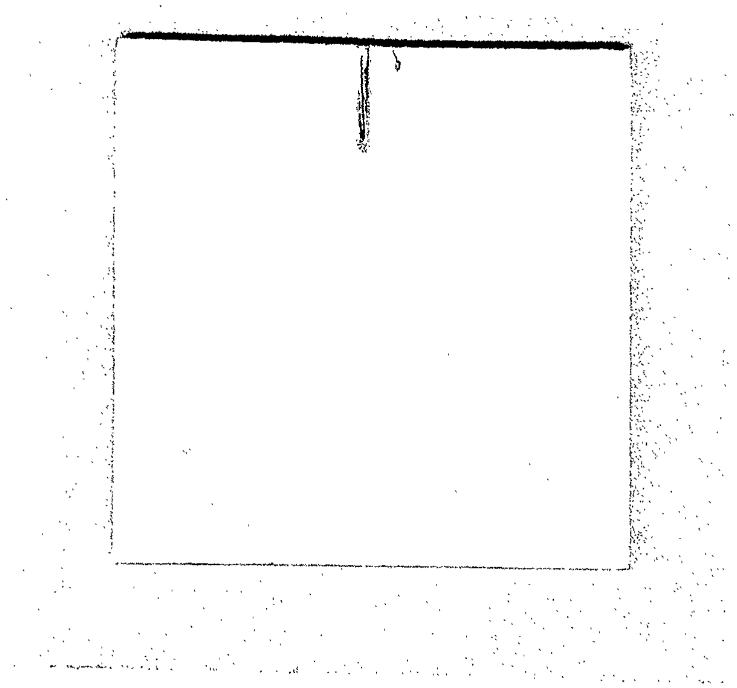

Fig. 2A

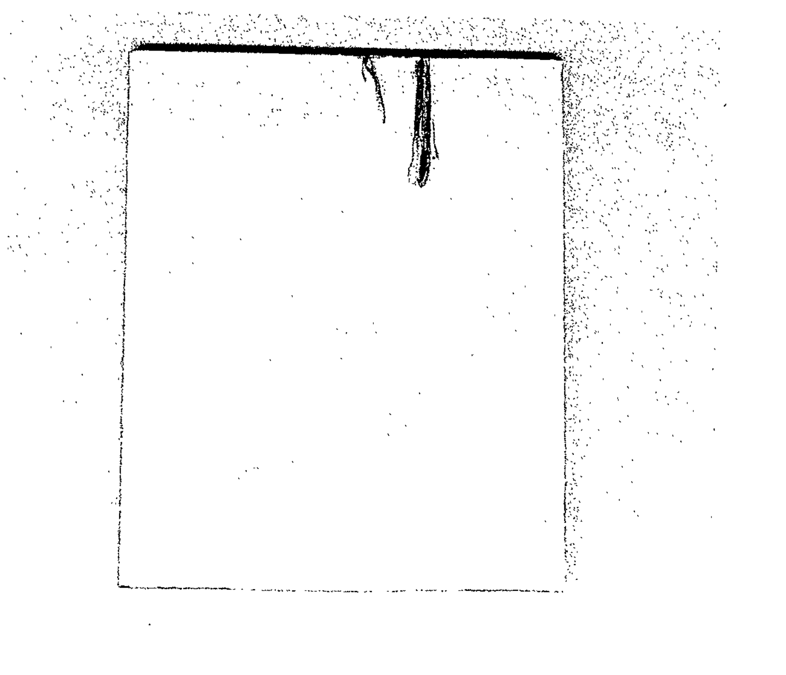

Fig. 2B